(19) Europäisches Patentamt
European Patent Office
Office européen des brevets

(11) **EP 3 087 615 B1**

(12) **EUROPEAN PATENT SPECIFICATION**

(45) Date of publication and mention
of the grant of the patent:
**09.10.2019 Bulletin 2019/41**

(51) Int Cl.:
***H01L 31/0749*** *(2012.01)*

(21) Application number: **14874607.6**

(22) Date of filing: **23.12.2014**

(86) International application number:
**PCT/CN2014/094607**

(87) International publication number:
**WO 2015/096689 (02.07.2015 Gazette 2015/26)**

(54) **LAYER SYSTEM FOR THIN-FILM SOLAR CELLS**

SCHICHTSYSTEM FÜR DÜNNFILMSOLARZELLEN

SYSTÈME DE COUCHES POUR PHOTOPILES EN COUCHES MINCES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.12.2013 EP 13199305**

(43) Date of publication of application:
**02.11.2016 Bulletin 2016/44**

(73) Proprietor: **Bengbu Design & Research Institute
for
Glass Industry
Bengbu, Anhui 233010 (CN)**

(72) Inventors:
• **PALM, Jorg**
  **80797 Munich (DE)**
• **POHLNER, Stephan**
  **81541 Munich (DE)**
• **HAPP, Thomas**
  **81825 Munich (DE)**
• **DALIBOR, Thomas**
  **82211 Herrsching am Ammersee (DE)**
• **DIETMUELLER, Roland**
  **80636 Munich (DE)**
• **VERMA, Rajneesh**
  **82008 Unterhaching (DE)**

(74) Representative: **Gebauer, Dieter Edmund
Splanemann
Patentanwälte Partnerschaft
Rumfordstraße 7
80469 München (DE)**

(56) References cited:
  EP-A1- 2 200 097          WO-A1-2013/077431
  CN-A- 102 130 202         CN-A- 102 169 910
  US-A- 5 252 140           US-A1- 2010 248 417
  US-A1- 2012 067 407       US-A1- 2012 103 411

• **RODRIGO SÁEZ-ARAOZ ET AL: "ILGAR In2S3
  buffer layers for Cd-free Cu(In,Ga)(S,Se)2 solar
  cells with certified efficiencies above 16%",
  PROGRESS IN PHOTOVOLTAICS: RESEARCH
  AND APPLICATIONS, 1 July 2012 (2012-07-01),
  pages n/a-n/a, XP055041070, ISSN: 1062-7995,
  DOI: 10.1002/pip.2268**

## Description

The present invention is in the technical area of the manufacture of solar cells and solar modules and relates to a layer system for thin-film solar cells as well as a method for producing such a layer system.

Thin-film systems for solar cells and solar modules are sufficiently known and available on the market in various designs depending on the substrate and the materials applied thereon. The materials are selected such that the incident solar spectrum is utilized to the maximum. Due to the physical properties and the technical handling qualities, thin-film systems with semiconductors of amorphous, micromorphous, or polycrystalline silicon, cadmium telluride (CdTe), gallium arsenide (GaAs), copper indium (gallium) selenide sulfide $(Cu(In,Ga) (S,Se)_2)$, and copper zinc tin sulfoselenide (CZTS from the group of the kesterites) as well as organic semiconductors are particularly suited for solar cells. The pentenary semiconductor $Cu(In,Ga) (S,Se)_2$ belongs to the group of chalcopyrite semiconductors that are frequently referred to as CIS (copper indium diselenide or copper indium disulfide) or CIGS (copper indium gallium diselenide, copper indium gallium disulfide, or copper indium gallium disulfoselenide). In the abbreviation CIGS, S can represent selenium, sulfur, or a mixture of the two chalcogens.

Current thin-film solar cells and solar modules based on $Cu(In,Ga) (S,Se)_2$ require a buffer layer between a p-conductive $Cu(In,Ga) (S,Se)_2$ absorber layer and an n-conductive front electrode. The front electrode usually includes zinc oxide (ZnO). According to current knowledge, this buffer layer enables electronic adaptation between the absorber material and the front electrode. Moreover, it offers protection against sputtering damage in the subsequent process step of deposition of the front electrode by DC-magnetron sputtering. Additionally, by constructing a high-ohm intermediate layer between p- and n-semiconductors, it prevents current drain from electronically good conductive zones into poor conductive zones.

To date, cadmium sulfide (CdS) has been most frequently used as a buffer layer. To be able to produce good efficiency of the cells, cadmium sulfide is wet-chemically deposited in a chemical bath process (CBD process). It is disadvantageous that the wet-chemical process does not fit well into the process cycle of current production of thin-film solar cells, characterized by vacuum processes. Another disadvantage of the CdS buffer layer consists in that it includes the toxic heavy metal cadmium. This creates higher production costs since increased safety precautions must be taken in the production process and the wastewater must be disposed of expensively. Another disadvantage of CdS buffer layers resides in the fact that cadmium sulfide is a semiconductor with an electronic bandgap of roughly 2.4 eV. Consequently, in a $Cu(In,Ga) (S,Se)_2$/ CdS/ZnO solar cell, already with CdS film thicknesses of a few 10 nm, the incident light is, to a large extent, absorbed. The light absorbed in the buffer layer is lost for the electrical yield since the charge carriers generated in this layer recombine right away and there are many crystal defects acting as recombination centers in this region of the heterojunction and in the buffer material. As a result, the efficiency of the solar cell is reduced, which is disadvantageous for a thin-film solar cell.

Consequently, various alternatives to cadmium sulfide have been tested for different absorbers from the family of the $Cu(In,Ga) (S,Se)_2$ semiconductors, e.g., sputtered ZnMgO, Zn(S,OH) deposited by CBD, In(O,OH) deposited by CBD, and indium sulfide deposited by atomic layer deposition (ALD), ion layer gas deposition (ILGAR), spray pyrolysis, or physical vapor deposition (PVD) processes, such as thermal evaporation or sputtering.

However, these materials are not suitable for commercial use, since the same efficiencies cannot be achieved as with a CdS buffer layer. The efficiency of a solar cell describes the ratio of incident power to the electrical power produced by a solar cell and is as much as roughly 20% for CdS buffer layers for lab cells on small surfaces and between 10% and 15% for large-area modules. Moreover, alternative buffer layers present excessive instabilities, hysteresis effects, or degradations in efficiency when they are exposed to light, heat, and/or moisture.

A layer system with a buffer layer based on indium sulfide is, for example, known from WO 2009141132 A2. However, in the development to date of these layer systems, it has been demonstrated that the efficiency of solar cells with an indium sulfide buffer layer is lower than that of solar cells with CdS buffer layers.

Consequently, the object of the present invention is to provide a layer system based on a chalcogenide compound semiconductor with a buffer layer that has high efficiency and high stability of a solar cell manufactured therefrom, with production that is economical and environmentally compatible.

This object is accomplished according to the invention by a layer system according to claim 1. Advantageous embodiments of the invention are indicated in the subclaims.

The layer system according to the invention comprises an absorber layer, which contains a chalcogenide compound semiconductor. In an advantageous embodiment of the invention, the chalcogenide compound semiconductor is a semiconductor of the chalcopyrite type of the formula $Cu(In,Ga,Al) (S,Se)_2$, in particular $CuInSe_2$, $CuInS_2$, $Cu(In,Ga)Se_2$, or $Cu(In,Ga) (S,Se)_2$. In another advantageous embodiment of the invention, the chalcogenide compound semiconductor is a semiconductor of the kesterite/stannite type of the formula $Cu_2ZnSn(S,Se)_4$, in particular $Cu_2ZnSnS_4$. In the formulas mentioned, the elements in parentheses can be present alone or in combination.

The layer system further comprises a buffer layer, which is arranged on the absorber layer. The buffer layer contains a semiconductor material, which has indium (In), sulfur (S), and at least one element, selected from the group consisting of potassium (K) and cesium (Cs). Thus, the elements potassium and cesium can in each case be contained alone or in combination in the buffer layer. The semiconductor material contained in the buffer layer is described by the formula $A_xIn_yS_z$ with A = K and/or Cs, where the values of the parameters x, y, z indicate the relative fraction of the respective substance in the semiconductor material described by the formula. The relative fraction of a substance (atom-%) in all substances that are mentioned in the formula results from the ratio of the value of the associated parameter (x or y or z) to the sum of the values of all parameters (x+y+z), which are indicated in the formula. If A = K or A = Cs, the value of the parameter x refers to the relative fraction of K or Cs of the substances indicated in the formula. For example, the formula $KIn_2S_3$ indicates that the relative fraction of of potassium in the substances indicated in the formula is 1/6, which corresponds to a content of ca. 17 atom-%. Indium is present in a relative fraction of the substances indicated in the formula of 2/6, corresponding to a content of ca. 33 atom-%. Sulfur is present in a relative fraction of the substances indicated in the formula of 3/6, corresponding to the content of 50 atom-%. It is understood that elements not mentioned here, in particular impurities, can be contained in the semiconductor material of the buffer layer. Thus, the indication of a relative fraction of a substance refers only to the substances mentioned in the formula.

If A = K and Cs, i.e., if the semiconductor material contains K and Cs in combination, the value of the parameter x refers to the total relative fraction of K and Cs in the substances mentioned in the formula. In concrete terms, the total relative fraction (total atomic fraction in atom-%) of K and Cs of all substances that are indicated in the formula results from the ratio of the value of the parameter x to the sum of the values of the parameters x, y, and z (i.e., x/(x+y+z)).

Since the elements of the buffer layer can, in each case, be present in different oxidation states, all oxidation states are referred to uniformly in the following with the name of the element unless explicitly indicated otherwise. For example, the term "potassium" means elemental potassium and potassium ions as well as potassium in a compound.

In one embodiment of the layer system according to the invention, the buffer layer contains a semiconductor material of the formula $A_xIn_yS_z$, which contains only potassium (no cesium). In another embodiment of the layer system according to the invention, the buffer layer contains a semiconductor material of the formula $A_xIn_yS_z$, which contains only cesium (no potassium). In another embodiment of the layer system according to the invention, the buffer layer contains a semiconductor material of the formula $A_xIn_yS_z$, with the semiconductor material containing both potassium and cesium.

As investigations of the inventors surprisingly showed, a clear increase in the efficiency of solar cells can be obtained through potassium and/or cesium in an indium sulfide-containing buffer layer. Without being restricted to this, it is currently assumed as the cause for the increase in efficiency that different crystalline structures are formed by potassium or cesium, which results, during layer growth, in a finer crystalline layer, compared to a potassium-free or cesium-free indium sulfide buffer layer. It is also assumed that the relatively large atomic radius of potassium or cesium disrupts the formation of the indium sulfide crystal structure and the also reduces crystallinity. This results in the fact that the inward diffusion of elements, for example, copper, from the absorber layer into the buffer layer is reduced, which increases the efficiency of the solar cell.

In addition, the bandgap of the buffer layer can be widened by the introduction of potassium and/or cesium into an indium sulfide-containing buffer layer. This is advantageous both for band adaptation at the absorber-buffer interface and for reduction of light absorption in the buffer layer. As the inventors were further able to observe, potassium and/or cesium in an indium sulfide-containing buffer layer have a relatively low diffusion tendency, with the result that only a small fraction diffuses out of the buffer layer into the absorber layer. Thus, short-circuit (shunt) paths, which could otherwise develop over the so-called PI structuring and limit the efficiency of solar modules and result in poorer low-light behavior, can advantageously be avoided. This opens the possibility of increasing the fraction of potassium and/or cesium in the buffer layer and widening the bandgap even more in order to obtain an improvement of transmittance in solar modules and thus an improvement in efficiency.

According to the invention, the buffer layer includes a semiconductor material of the formula $A_xIn_yS_z$ with A = K and/or Cs of the following composition: $0.015 \leq x/(x+y+z) \leq 0.25$ and $0.30 \leq y/(y+z) \leq 0.45$. Advantageously, the following compositions are present: $0.02 \leq x/(x+y+z) \leq 0.25$ and $0.30 \leq y/(y+z) \leq 0.45$; or $0.03 \leq x/(x+y+z) \leq 0.25$ and $0.30 \leq y/(y+z) \leq 0.45$; or $0.04 \leq x/(x+y+z) \leq 0.25$ and $0.30 \leq y/(y+z) \leq 0.45$. In these ranges, a significant improvement in efficiency of solar cells can advantageously be obtained.

In an advantageous embodiment of the layer system according to the invention, the buffer layer includes a semiconductor material of the formula $A_xIn_yS_z$ mit A = K and/or Cs of the following composition: $0.05 \leq x/(x+y+z) \leq 0.25$ and $0.30 \leq y/(y+z) \leq 0.45$. In these ranges, a particularly high improvement in efficiency of solar cells can advantageously be obtained. Particularly advantageously, the semiconductor material has the following composition: $0.05 \leq x/(x+y+z) \leq 0.20$ and $0.30 \leq y/(y+z) \leq 0.45$. For these values, it was possible to measure particularly high efficiencies.

In another advantageous embodiment of the layer system according to the invention, the buffer layer includes a potassium indium sulfide semiconductor material of the formula $K_x In_y S_z$ with $0.05 \leq x/(x+y+z) \leq 0.15$ and $0.35 \leq y/(y+z) \leq 0.45$. For these values, it was possible to measure particularly high efficiencies.

In another advantageous embodiment of the layer system according to the invention, the buffer layer includes a cesium indium sulfide semiconductor material of the formula $Cs_x In_y S_z$ with $0.05 \leq x/(x+y+z) \leq 0.12$ and $0.35 \leq y/(y+z) \leq 0.45$. For these values, it was possible to measure particularly high efficiencies.

In another advantageous embodiment of the layer system according to the invention, the buffer layer has at least one halogen, selected in particular from the group consisting of fluorine (F), chlorine (Cl), bromine (Br), and iodine (I). Advantageously, a halogen content of the buffer layer corresponds to an alkali content of the buffer layer, which can result, for example, from the stoichiometry with the introduction of potassium or cesium as a a halogen compound. As investigations of the applicant have shown, the optical bandgap of the buffer layer can be widened even more by halogen such that the efficiency of a solar cell can be even further improved.

In another advantageous embodiment of the invention, the layer system includes an $A_x In_y S_z$-containing buffer layer implemented as described above, which is referred to as "first buffer layer", and a second buffer layer, wherein the second buffer layer is arranged on the first buffer layer. The second buffer layer preferably contains non-doped zinc oxide (Zno) and/or non-doped zinc magnesium oxide (ZnMgO). With this structure, solar cells with particularly high efficiency can be produced.

In another advantageous embodiment of the layer system according to the invention, the (first) buffer layer contains zinc (Zn), with the zinc content a maximum of 15 atom-%, based on the elements of the buffer layer. Preferably, the zinc content of the first buffer layer rises to the second buffer layer.

In another advantageous embodiment of the layer system according to the invention, the buffer layer has a layer thickness in the range from 5 nm to 150 nm, in particular in the range from 15 nm to 60 nm.

In another advantageous embodiment of the layer system according to the invention, the buffer layer is implemented such that a bandgap of the buffer layer in the range from 2 electron volts (eV) to 2.8 electron volts (eV) is present. With this, solar cells with particularly high efficiency can be produced.

In another advantageous embodiment, the buffer layer according to the invention contains a mole fraction of copper of $\leq 10$ atom-%. The inward diffusion of larger amounts of copper from the absorber layer is disadvantageous since the bandgap of the buffer layer is reduced by copper. This results in increased absorption of light in the buffer layer and thus in a reduction in efficiency. As investigations of the inventor have shown, the use of potassium and/or cesium in the buffer layer results in advantageous inhibition of inward diffusion of copper from the absorber layer into the buffer layer. With a mole fraction of copper in the buffer layer $\leq 10$ atom-%, high efficiency of the solar cell can be ensured.

In general, the buffer layer is composed (or is made) of a semiconductor material of the formula $A_x In_y S_z$, where A is potassium (K) and/or cesium (Cs), with $0.015 \leq x/(x+y+z) \leq 0.25$ and $0.30 \leq y/(y+z) \leq 0.45$, and one or a plurality of other components (impurities) different from the semiconductor material. In an advantageous embodiment of the invention, the buffer layer is made substantially of the semiconductor material mentioned. This means that the buffer layer components (impurities) different from the semiconductor material mentioned have a negligible fraction.

If not based on the elements of the molecular formula of the semiconductor material of the buffer layer, the mole fraction of a substance (impurity) describes in atom-% the fraction amount of substance of this substance based on the sum of the amounts of substance of all substances in the buffer layer (i.e., based on the semiconductor material of the buffer layer and impurities).

It is possible that the buffer layer components (impurities) different from the semiconductor material mentioned of the buffer layer have a non-negligible fraction such that the buffer layer consists of the semiconductor material mentioned and components different from the semiconductor material. In this case, it is advantageous for the percentage fraction (atom-%) of the semiconductor material of the formula $A_x In_y S_z$, where A is potassium (K) and/or cesium (Cs), with $0.015 \leq x/(x+y+z) \leq 0.25$ and $0.30 \leq y/(y+z) \leq 0.45$, (i.e., the sum of the respective percentage fractions (atom-%) of the elements of the semiconductor material) in the buffer layer to be at least 75%, preferably at least 80%, more preferably at least 85%, even more preferably at least 90%, even more preferably at least 95%, and most preferably at least 99%. The buffer layer thus consists of at least 75% of the semiconductor material mentioned and a maximum of 25% of components different from the semiconductor material, preferably of at least 80% of the semiconductor material mentioned and a maximum of 20% of components different from the semiconductor material, more preferably of at least 85% of the semiconductor material mentioned and a maximum of 15% of components different from the semiconductor material, even more preferably of at least 90% of the semiconductor material mentioned and a maximum of 10% of components different from the semiconductor material, even more preferably of at least 95% of the semiconductor material mentioned and a maximum of 5% of components different from the semiconductor material, and most preferably of at least 99% of the semiconductor material mentioned and a maximum of 1% of components different from the semiconductor material (all data in atom-%).

In a particularly advantageous embodiment of the invention, the sum of the mole fractions of all impurities (i.e., all substances that are different from the semiconductor material according to the molecular formula $A_x In_y S_z$, where A is potassium (K) and/or cesium (Cs), with $0.015 \leq x/(x+y+z) \leq 0.25$ and $0.30 \leq y/(y+z) \leq 0.45$, in the buffer layer is a maximum of 25 atom-%, preferably a maximum of 20 atom-%, more preferably a maximum of 15 atom-%, even more preferably a maximum of 10 atom-%, even more preferably a maximum of 5 atom-%, and most preferably a maximum of 1 atom-%.

In an advantageous embodiment of the layer structure according to the invention, the buffer layer has no substantial fraction of elements other than potassium and/or cesium, indium, and sulfide (as well as possibly a halogen, for example, chlorine, if potassium or cesium was deposited in a halogen compound). This means that the buffer layer is not provided with further elements, such as, for example, carbon and contains, at most, mole fractions of other elements of $\leq 1$ atom-% unavoidable from a production technology standpoint. This makes it possible to ensure high efficiency.

In the layer system according to the invention, the fraction of potassium and/or cesium in the buffer layer can have a constant depth profile. In the context of the present invention, "depth profile" describes the direction orthogonal to the layers of the layer structure, which means the direction parallel to the thickness of the individual layers of the layer structure. Alternatively, the fraction of potassium and/or cesium in the buffer layer can have a non-constant depth profile. For example, the fraction of potassium and/or cesium in the buffer layer has a gradient that drops from the surface nearer the absorber layer to the surface of the buffer layer farther from the absorber layer. It is equally possible for the fraction of potassium and/or cesium in the buffer layer to have a gradient that rises from the surface nearer the absorber layer to the surface of the buffer layer farther from the absorber layer. It is likewise possible for the fraction of potassium and/or cesium in the buffer layer to have a gradient that initially drops from the surface nearer the absorber layer to the surface of the buffer layer farther from the absorber layer and then rises again, i.e., has a minimum between the two surfaces. Moreover, it is possible for the fraction of potassium and/or cesium in the buffer layer to have a gradient that initially rises from the surface nearer the absorber layer to the surface of the buffer layer farther from the absorber layer and then drops again, i.e., has a maximum between the two surfaces. The mole fractions of the individual elements in the total buffer layer remain within the ranges claimed in the scope of the invention. A non-constant depth profile can, for example, be produced by means of a variable vapor deposition rate.

The invention further extends to a thin-film solar cell that comprises a substrate, a rear electrode, which is arranged on the substrate, a layer system implemented as described above, which is arranged on the rear electrode, and a front electrode, which is arranged on the layer system. The substrate is, for example, a metal, glass, plastic, or ceramic substrate, glass being preferred. However, other transparent carrier materials can also be used, in particular plastics. The rear electrode advantageously includes molybdenum (Mo) or other metals. In an advantageous embodiment of the rear electrode, it has a molybdenum sublayer, which adjoins the absorber layer, and a silicon nitride sublayer (SiN), which adjoins the molybdenum sublayer. Such rear electrode systems are known, for example, from EP 1356528 A1. The front electrode preferably includes a transparent conductive oxide (TCO), particularly preferably aluminum-, gallium-, or boron-doped zinc oxide and/or indium tin oxide (ITO).

In an advantageous embodiment of the thin-film solar cell according to the invention, a second buffer layer is arranged between the buffer layer and the front electrode. The second buffer layer preferably includes non-doped zinc oxide and/or non-doped zinc magnesium oxide.

The invention further extends to a method for producing a layer system according to the invention - implemented as described above.

The method includes a step wherein an absorber layer, implemented as described above, which contains a chalcogenide compound semiconductor, is prepared. Expediently, the absorber layer is applied in an RTP ("rapid thermal processing") process on a substrate with a rear electrode. For $Cu(In,Ga)(S,Se)_2$ absorber layers, a precursor layer is first deposited on the rear electrode. The precursor layer includes the elements copper, indium, and/or gallium, which are applied by sputtering. In addition, the precursor layer contains elemental selenium and/or elemental sulfur, which are applied by thermal evaporation. During these processes, the substrate temperature is below 100°C such that the elements substantially remain unreacted. Then, this precursor layer is reacted in the rapid thermal process in a sulfur-containing and/or selenium-containing atmosphere to form a $Cu(In,Ga)(S,Se)_2$ chalcopyrite semiconductor.

The method further includes a step wherein a buffer layer is arranged on the absorber layer, wherein the buffer layer contains $A_x In_y S_z$, where A is potassium and/or cesium. The buffer layer is implemented corresponding to the buffer layer of the above described layer system. In particular, a buffer layer is produced that has a semiconductor material of the formula $A_x In_y S_z$ with $0.015 \leq x/(x+y+z) \leq 0.25$ and $0.30 \leq y/(y+z) \leq 0.45$.

In principle, for the production of the buffer layer, all chemical-physical deposition methods in which the ratio of the fraction of potassium or cesium to the indium sulfide fraction can be controlled are suitable. Advantageously, the buffer layer according to the invention is applied to the absorber layer by atomic layer deposition (ALD), ion layer gas deposition (ILGAR), spray pyrolysis, chemical vapor deposition (CVD), or physical vapor deposition (PVD). The buffer layer according to the invention is preferably deposited by sputtering (cathodic sputtering), thermal evaporation, or electron beam evaporation, particularly preferably from separate sources for potassium (preferably in the form of a potassium halogen compound) and/or cesium (preferably in the form of a cesium halogen compound) and indium sulfide. Indium sulfide evaporated either from separate sources for indium and sulfur or from one source with an $In_2S_3$ compound semiconductor material. Other indium sulfides ($In_6S_7$ or $InS$) are also possible in combination with a sulfur source.

Particularly advantageously, the buffer layer according to the invention is deposited with a vacuum method. The vacuum method has the particular advantage that, under a vacuum, the incorporation of oxygen or hydroxide is prevented. Hydroxide components in the buffer layer are believed to be responsible for transients in efficiency under the effect of heat and light. Moreover, vacuum methods have the advantage that the method does without wet chemistry and standard vacuum coating equipment can be used.

In a particularly advantageous embodiment of the method according to the invention, the buffer layer is produced on the basis of at least one potassium compound and indium sulfide and/or on the basis of at least one cesium compound and indium sulfide. At least one potassium compound and indium sulfide are used as starting materials (sources) and/or at least one cesium compound and indium sulfide are used as starting materials (sources) for producing the buffer layer. By means of the formulation according to which the buffer layer is produced "on the basis of at least one potassium compound and indium sulfide and/or on the basis of at least one cesium compound and indium sulfide", both the case that the stoichiometry of the buffer layer does not deviate relative to the stoichiometry of the components of the starting materials and also the case that the stoichiometry of the buffer layer deviates relative to the stoichiometry of the starting materials are included.

In a particularly advantageous embodiment of the method according to the invention, the buffer layer is produced on the basis of at least one potassium halide and/or at least one binary potassium compound, in particular potassium sulfide, and/or at least one ternary potassium compound, in particular at least one ternary potassium indium sulfur compound, for example, $KInS_2$, $KIn_3S_5$, $KIn_5S_6$, $KIn_5S_7$, and/or $KIn_5S_8$, and/or at least one cesium halide and/or at least one binary cesium compound, in particular cesium sulfide, and/or at least one ternary cesium compound, in particular at least one ternary cesium indium sulfur compound, for example, $CsInS_2$, $CsIn_3S_5$, $CsIn_5S_6$, $CsIn_5S_7$, and/or $CsIn_5S_8$. Here and in the following, the term "ternary potassium compound" means a ternary chemical compound that is composed of potassium (K) and two other elements. In particular, a "ternary indium sulfur compound" is a ternary chemical compound that is composed of the elements potassium (K), indium (In), and sulfur (S). Likewise, the term "ternary cesium compound" means a ternary chemical compound that is composed of cesium (Cs) and two other elements. In particular, a "ternary cesium indium sulfur compound" is a ternary chemical compound that is composed of the elements cesium (K), indium (In), and sulfur (S). The elements can in each case be present in various oxidation states.

The use of a ternary potassium compound, in particular a ternary potassium indium sulfur compound, as well as a ternary cesium compound, in particular a ternary cesium indium sulfur compound for producing the buffer layer brings with it substantial process-technology advantages. One important advantage is the simple handling quality of the ternary compounds with regard to hygroscopy, toxicity, and flammability.

According to one advantageous embodiment of the method according to the invention, the buffer layer is produced by deposition of at least one potassium compound and indium sulfide and/or by deposition of at least one cesium compound and indium sulfide. In this case, the stoichiometry of the buffer layer corresponds to the stoichiometry of the components of the starting materials.

In an advantageous embodiment, a potassium compound and/or a cesium compound is evaporated out of one or a plurality of first sources and indium sulfide ($In_2S_3$) is evaporated out of a separate, second source.

The arrangement of the deposition sources is, for example, designed such that the steam beams of the sources overlap at least partially, in particular completely. By this means, a very homogeneous buffer layer can be generated, by means of which particularly high efficiencies are obtained. In the context of the invention, "steam beam" means the region in front of the outlet of the source that is technically suitable for the deposition of the evaporated material on a substrate in terms of deposition rate and homogeneity. The source is, for example, an effusion cell, a boat or crucible of a thermal evaporator, a resistance heater, an electron beam evaporator, or a linear evaporator.

In an alternative arrangement, the steam beams of the sources overlap only partially or not at all. Preferably, the potassium compound and/or cesium compound is deposited before the indium sulfide, by which means, an electrical interface passivation of the absorber layer can be particularly advantageously obtained. This can increase the service life of the charge carriers, which improves the efficiency of the solar cell.

In an advantageous embodiment of the method according to the invention, the absorber layer is conveyed, in an in-line method or in a rotation method, past a steam beam of a potassium compound and/or a cesium compound and a steam beam of indium sulfide or steam beams of indium and sulfur. The steam beams overlap completely or partially.

The invention further extends to an alternative method for producing a layer system according to the invention - implemented as described above.

The method includes a step wherein an absorber layer implemented as described above, which includes a chalcogenide compound semiconductor, is prepared. With regard to this step, reference is made to the statements of the preceding method. The method further includes a step wherein a buffer layer corresponding to the buffer layer of the above-described layer system according to the invention is arranged on the absorber layer. In particular, a buffer layer is produced, which has a semiconductor material of the formula $A_xIn_yS_z$ with $0.015 \leq x/(x+y+z) \leq 0.25$ and $0.30 \leq y/(y+z) \leq 0.45$. It is essential here that the buffer layer is produced (only) on the basis of at least one ternary potassium indium sulfur compound, for example, $KInS_2$, $KIn_3S_5$, $KIn_5S_6$, $KIn_5S_7$, and/or $KIn_5S_8$, and/or (only) on the basis of at least one ternary cesium indium sulfur compound, for example, $CsInS_2$, $CsIn_3S_5$, $CsIn_5S_6$, $CsIn_5S_7$, and/or $CsIn_5S_8$. In contrast to the preceding method, the buffer layer is thus not produced on the basis of indium sulfide, e.g., no indium sulfide is used as a starting material for the production of the buffer layer.

The use of a ternary potassium indium sulfur compound as well as a ternary cesium indium sulfur compound for producing the buffer layer brings with it, as already mentioned, substantial process-technology advantages in terms of handling quality, hygroscopy, toxicity, and flammability. In addition, the production of the buffer layer is possible with a relatively small number of starting materials (in the simplest case, only one ternary potassium indium sulfur compound or one ternary cesium indium sulfur compound), by which means the complexity of the production process and thus the costs of producing the layer system are significantly reduced.

In principle, for producing the buffer layer on the basis of at least one ternary potassium indium sulfur compound and/or on the basis of at least one ternary cesium indium sulfur compound, all chemical-physical deposition methods are suitable. Advantageously, the buffer layer according to the invention is applied on the absorber layer by atomic layer deposition (ALD), ion layer gas deposition (ILGAR), spray pyrolysis, chemical vapor deposition (CVD), or physical vapor deposition (PVD). The buffer layer according to the invention is preferably deposited by sputtering (cathodic sputtering), thermal evaporation, or electron beam evaporation. The buffer layer according to the invention is particularly advantageously deposited with a vacuum method. The vacuum method has the particular advantage that in the vacuum, the incorporation of oxygen or hydroxide is prevented.

According to an advantageous embodiment of the method according to the invention, the buffer layer is produced by deposition of at least one ternary potassium indium sulfur compound and/or at least one ternary cesium indium sulfur compound. In this case, the stoichiometry of the buffer layer with regard to the elements potassium and/or cesium and indium and sulfur corresponds to the stoichiometry of these components of the starting materials.

According to another advantageous embodiment of the method according to the invention, in step b), the buffer layer is deposited out of the gas phase onto the absorber layer, wherein the concentration of at least one component of the material to be deposited is reduced by selective bonding in its gas phase, and thus, before its deposition on the absorber layer, compared to the concentration of this component in the starting material (potassium indium sulfur compound and/or cesium indium sulfur compound). Thus, for example, the concentration of the component sulfur can be reduced in its gas phase compared to the concentration in the starting material. In this case, the stoichiometry of the buffer layer with regard to the components potassium and/or cesium, indium and sulfur no longer corresponds to the stoichiometry of these components in the starting material. The concentration of a component can be reduced in the gas phase, for example, by a getter element, onto which the component bonds physically and/or chemically. The various measures for reducing the concentration of a component in its gas phase are well-known per se to the person skilled in the art, for example, from the international patent application WO 2011/104235, such that this need not be dealt with in detail here. By this means, it is advantageously possible to selectively influence the stoichiometry of the components potassium and/or cesium, indium, and sulfur in the buffer layer in particular to further improve the efficiency of the solar cells.

For example, the buffer layer is produced by using at least one first source with at least one potassium indium sulfur compound and/or at least one second source with at least one cesium indium sulfur compound. The arrangement of the deposition sources is, for example, designed such that the steam beams of the sources overlap at least partially, in particular completely. By this means, a very homogeneous buffer layer can be generated, by means of which particularly high efficiencies are obtained. In the context of the invention, "steam beam" means the region in front of the outlet of the source that is technically suitable for the deposition of the evaporated material on a substrate in terms of deposition rate and homogeneity. The source is, for example, an effusion cell, a boat or crucible of a thermal evaporator, a resistance heater, an electron beam evaporator, or a linear evaporator. In an alternative arrangement, the steam beams of the sources overlap only partially or not at all. In an advantageous embodiment of the method according to the invention, the absorber layer is conveyed, in an in-line method or in a rotation method, past one or a plurality of first steam beams and/or past one or a plurality of second steam beams.

The various embodiments of the invention can be present alone or in any combination without departing from the scope of the invention.

The invention is explained in detail in the following with reference to the accompanying figures. They depict:

Fig. 1     a schematic cross-sectional view of a thin-film solar cell according to the present invention;

Fig.2      a measurement of the efficiency of a thin-film solar cell with the structure of Fig. 1 as a function of the potassium fraction in the buffer layer;

Fig. 3    a measurement of the efficiency of a thin-film solar cell with the structure of Fig. 1 as a function of the cesium fraction in the buffer layer;

Fig. 4    a measurement of the bandgap of $K_xIn_yS_z$ buffer layers or $Na_xIn_yS_z$ buffer layers as a function of the alkali fraction;

Fig. 5    a measurement of the optical transmittance of $Cs_xIn_yS_z$ buffer layers as a function of the cesium fraction;

Fig. 6    a measurement of the efficiency of thin-film solar modules of a thin-film solar cell with cesium-containing or sodium-containing indium sulfide buffer layers;

Fig. 7    a measurement of the short-circuit current of the thin-film solar modules of Fig. 6;

Fig. 8    a schematic representation of an in-line method for producing the buffer layer of the layer system according to the invention;

Fig. 9    a schematic representation of a rotation method for producing the buffer layer of the layer system according to the invention.

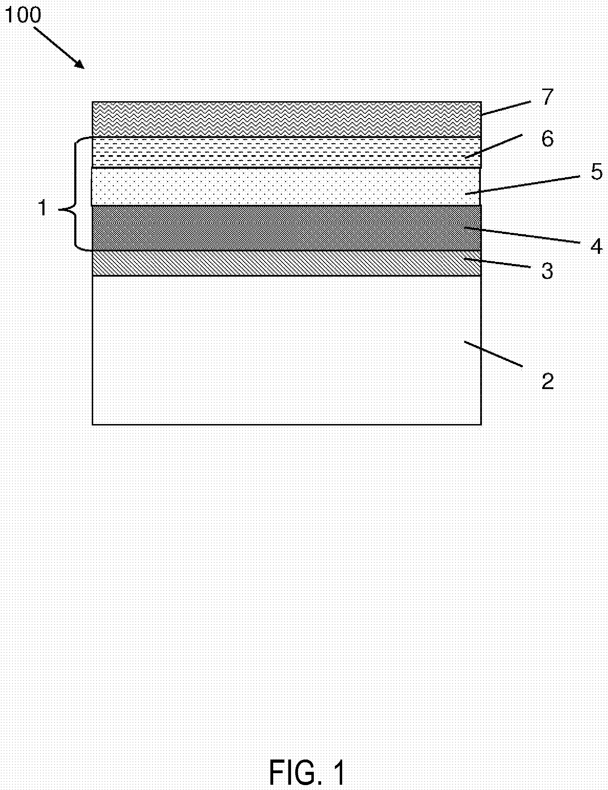

Fig. 1 depicts, purely schematically, an exemplary embodiment of a thin-film solar cell 100 according to the invention with a layer system 1 according to the invention in a cross-sectional view. The thin-film solar cell 100 includes a substrate 2 and a rear electrode 3. The layer system 1 according to the invention is arranged on the rear electrode 3. The layer system 1 according to the invention comprises an absorber layer 4, a first buffer layer 5, as well as, optionally, a second buffer layer 6. A front electrode 7 is arranged on the layer system 1.

The substrate 2 is made here, for example, of inorganic glass, with it equally possible to use other insulating materials with sufficient stability as well as inert behavior relative to the process steps performed during production of the thin-film solar cell 100, for example, plastics, in particular polymers or metals, in particular metal alloys. Depending on the layer thickness and the specific material properties, the substrate 2 can be implemented as a rigid plate or flexible film. In the present exemplary embodiment, the layer thickness of the substrate 2 is, for example, from 1 mm to 5 mm.

The rear electrode 3 is arranged on the light-entry-side surface of the substrate 2. The rear electrode 3 is made, for example, from an opaque metal. It can, for example, be deposited on the substrate 2 by vapor deposition or magnetic field-assisted cathodic sputtering. The rear electrode 3 is made, for example, of molybdenum (Mo), aluminum (Al), copper (Cu), titanium (Ti), or of a multilayer system with such a metal, for example, molybdenum (Mo). The layer thickness of the rear electrode 3 is, in this case, less than 1 $\mu$m, preferably in the range from 300 nm to 600 nm, and is, for example, 500 nm. The rear electrode 3 serves as a back-side contact of the thin-film solar cell 100. An alkali barrier, made, for example, of $Si_3N_4$, SiON, or SiCN, can be arranged between the substrate 2 and the rear electrode 3. This is not shown in detail in Fig. 1.

The layer system 1 according to the invention is arranged on the rear electrode 3. The layer system 1 includes an absorber layer 4, made, for example, of $Cu(In,Ga)(S,Se)_2$, which is applied directly on the rear electrode 3. The absorber layer 4 was deposited, for example, with the RTP process described in the introduction and has, for example, a thickness of 1.5 $\mu$m.

The first buffer layer 5 is arranged on the absorber layer 4. The first buffer layer 5 contains a semiconductor material of the formula $K_xIn_yS_z$ or $Cs_xIn_yS_z$ with $0.05 \leq x/(x+y+z) \leq 0.25$ and $0.30 \leq y/(y+z) \leq 0.45$, preferably $0.05 \leq x/(x+y+z) \leq 0.20$ and $0.35 \leq y/(y+z) \leq 0.45$.

For $K_xIn_yS_z$, the following preferably applies: $0.05 \leq x/(x+y+z) \leq 0.15$ and $0.35 \leq y/(y+z) \leq 0.45$. For $Cs_xIn_yS_z$, the following preferably applies: $0.05 \leq x/(x+y+z) \leq 0.12$ and $0.35 \leq y/(y+z) \leq 0.45$.

As was already mentioned in the introduction, the first buffer layer 5 advantageously has, in addition to a halogen, if potassium or cesium was deposited in a halogen compound, no significant fraction ($\leq$ 1 atom-%) of other elements. The layer thickness of the buffer layer 5 is preferably in the range from 15 nm to 60 nm and is, for example, 30 nm.

The second buffer layer 6 is arranged above the first buffer layer 5. The second buffer layer 6 is optional, i.e., it does not necessarily have to be present in the layer system 1. The buffer layer 6 contains, for example, non-doped zinc oxide (i-ZnO).

The front electrode 7 that serves as a front-side contact and is transparent to radiation in the visible spectral range ("window layer") is arranged above the second buffer layer 6. Usually, a doped metal oxide (TCO = transparent conductive oxide), for example, n-conductive, aluminum (Al)-doped zinc oxide (ZnO), boron (B)-doped zinc oxide (ZnO), or gallium (Ga)-doped zinc oxide (ZnO), is used for the front electrode 7. The layer thickness of the front electrode 7 is, for example, roughly 300 to 1500 nm. For protection against environmental influences, a plastic layer (encapsulation film) made, for example, of polyvinyl butyral (PVB), ethylene vinyl acetate (EVA), or DNP can be applied to the front electrode 7.

In addition, a cover plate transparent to sunlight that is made, for example, from extra white glass (front glass) with a low iron content and has a thickness of, for example, 1 to 4 mm, can be provided.

The basic structure of a thin-film solar cell or a thin-film solar module is well known to the person skilled in the art, for example, from commercially available thin-film solar cells or thin-film solar modules and has also already been described in detail in numerous printed documents in the patent literature, for example, DE 19956735 B4.

In the substrate configuration depicted in Fig. 1, the rear electrode 3 adjoins the substrate 2. It is understood that the layer system 1 can also have a superstrate configuration, in which the substrate 2 is transparent and the front electrode 7 is arranged on a surface of the substrate 2 facing away from the light-entry side.

The layer system 1 can serve for production of integrated serially connected thin-film solar cells, with the layer system 1, the rear electrode 3, and the front electrode 7 patterned in a manner known per se by various patterning lines ("PI" for rear electrode, "P2" for contact front electrode/rear electrode, and "P3" for separation of the front electrode).

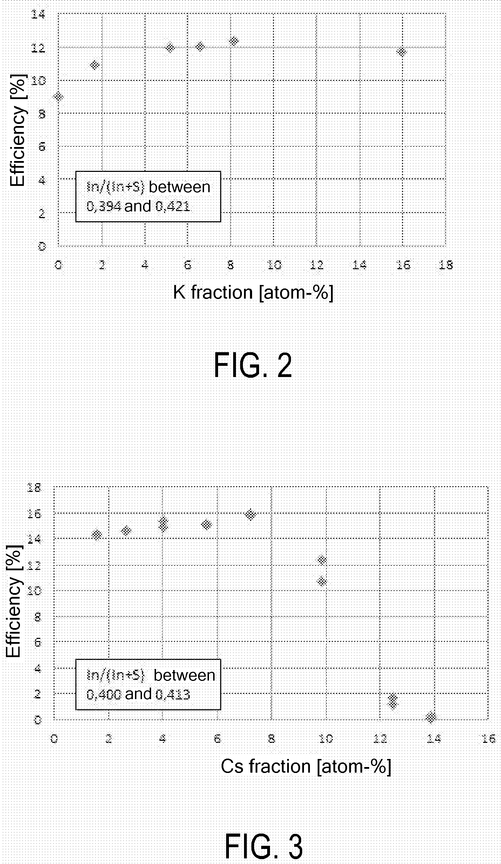

Fig. 2 depicts a diagram of the efficiency of thin-film solar cells 100 according to the structure of Fig. 1 as a function of the potassium fraction in the first buffer layer 5, which has a semiconductor material of the formula $K_xIn_yS_z$. The thin-film solar cell 100 contains a substrate 2 made of glass as well as a rear electrode 3 made of a $Si_3N_4$ barrier layer and a molybdenum layer. An absorber layer 4 made of $Cu(In,Ga)(S,Se)_2$, which was deposited according to the above described RTP process, is arranged on the rear electrode 3. The first buffer layer 5 is arranged on the absorber layer 4. The layer thickness of the first buffer layer 5 is 30 nm. A 100-nm-thick second buffer layer 6, which contains non-doped zinc oxide, is arranged on the first buffer layer 5. A 1200-nm-thick front electrode 7, which contains n-conductive zinc oxide, is arranged on the second buffer layer 6. The area of the thin-film solar cell 100 is, for example, 1.4 cm$^2$.

As indicated in Fig. 2, indium and sulfur are present in the first buffer layer 5 in the following molar ratio: $0.394 \leq y/(y+z) \leq 0.421$. The potassium fraction of the first buffer layer 5 varies from 0 atom-% to 16 atom-%. The measurements yielded a maximum efficiency of ca. 12.5%, by means of which it is discernible that the efficiency is clearly above the efficiency (ca. 9%) of the comparable solar cell without potassium in the first buffer layer 5.

Fig. 3 depicts a diagram of the efficiency of thin-film solar cells 100 according to the structure of Fig. 1 as a function of the cesium fraction in the first buffer layer 5, which has a semiconductor material of the formula $Cs_xIn_yS_z$. The solar cells of the structure of Fig. 3 correspond to those of Fig. 2, with the exception that the indium sulfide-containing semiconductor material of the first buffer layer 5 was provided with cesium.

As indicated in Fig. 3, indium and sulfur are present in the first buffer layer 5 in the following molar ratio: $0.400 \leq y/(y+z) \leq 0.413$. The cesium fraction of the first buffer layer 5 varies from ca. 1.5 atom-% to ca. 14 atom-%. The measurements yielded a maximum efficiency of ca. 16%, with the efficiency up to a cesium fraction of ca. 8 atom-% clearly above 14% and dropping off after a cesium fraction of ca. 10 atom-%.

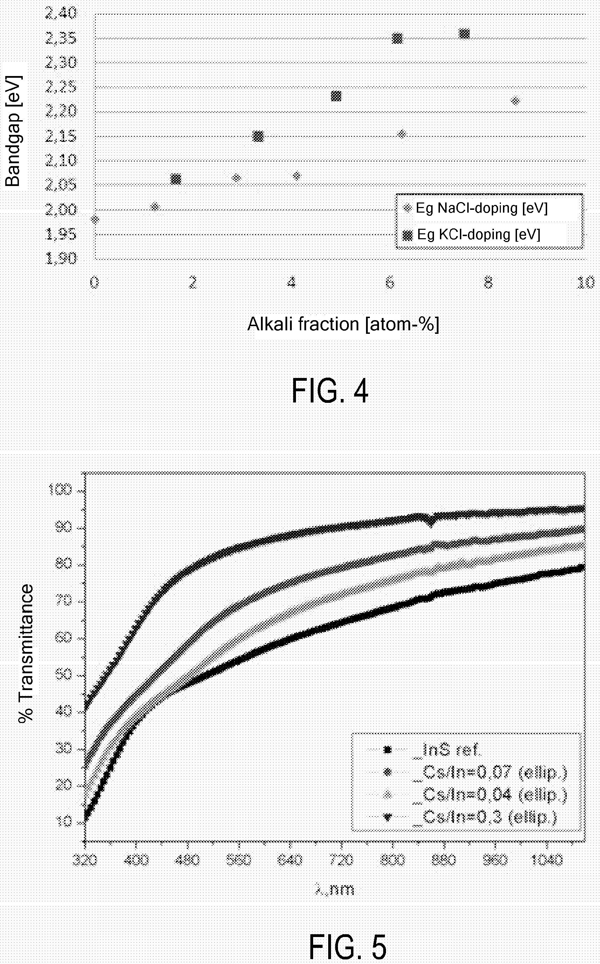

Fig. 4 depicts a measurement of the optical bandgap $E_g$ in electron volts (eV) as a function of the potassium content of $K_xIn_yS_z(:Cl)$ buffer layers produced by co-evaporation of KC1 and InS. As a comparative measurement, the optical bandgap $E_g$ is shown as a function of the sodium content of $Na_xIn_yS_z(:Cl)$ buffer layers produced by co-evaporation of NaCl and InS. Das the quantity ratio y/(y+z) was ca. 0.39 to 0.42. The bandgap was determined using ellipsometry, the potassium content, using x-ray fluorescence analysis (XRFA) via the chlorine content.

As emerges from Fig. 4, the bandgap increases with a potassium content in the range from 0 to 10.5 atom-% nearly linearly from ca. 2 eV to almost 2.5 eV, which results, in a thin-film solar cell, in a corresponding increase of the short-circuit current due to reduced absorption. The bandgaps of the Na-containing indium sulfide buffer layers are clearly under those of the K-containing indium sulfide buffer layers.

Fig. 5 depicts a measurement of the optical transmittance of $Cs_xIn_yS_z$ buffer layers on glass as a function of the cesium fraction. The respective cesium content in the buffer layer is indicated in the diagram, with the lowest curve referring, as a reference measurement, to a cesium-free indium sulfide buffer layer.

In Fig. 5, it is clearly discernible that with an increasing cesium fraction, the beginning of transmittance shifts to smaller wavelengths, which is caused by a widening of the bandgap. Overall, an improvement of transmittance can be observed with increasing cesium content.

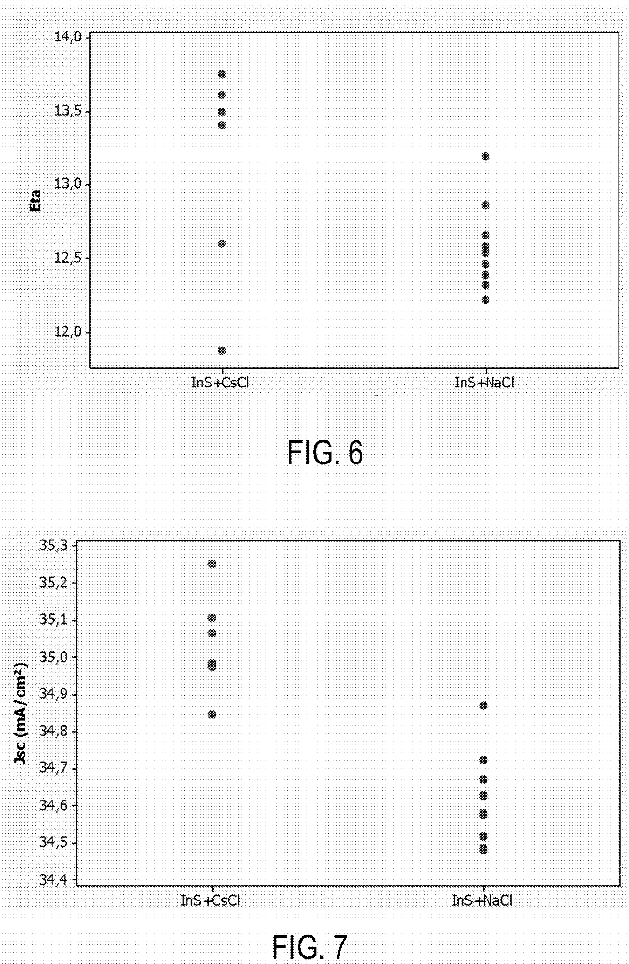

Fig. 6 depicts a comparison of the efficiencies of thin-film solar modules with an $In_yS_z:CsCl$ buffer layer (left) and an $In_yS_z:NaCl$ buffer layer (right). Obviously, clearly higher efficiencies can be obtained with a buffer layer with a cesium-containing indium sulfide semiconductor material than with a buffer layer with a sodium-containing indium sulfide semiconductor material.

In Fig. 7, the associated short-circuit current Isc (mA/cm$^2$) is shown. A significant increase of the short-circuit current is observed for solar modules with a buffer layer with a cesium-containing indium sulfide semiconductor material compared to a buffer layer mit a sodium-containing indium sulfide semiconductor material. The introduction of CsCl into the buffer layer thus improves the transmittance.

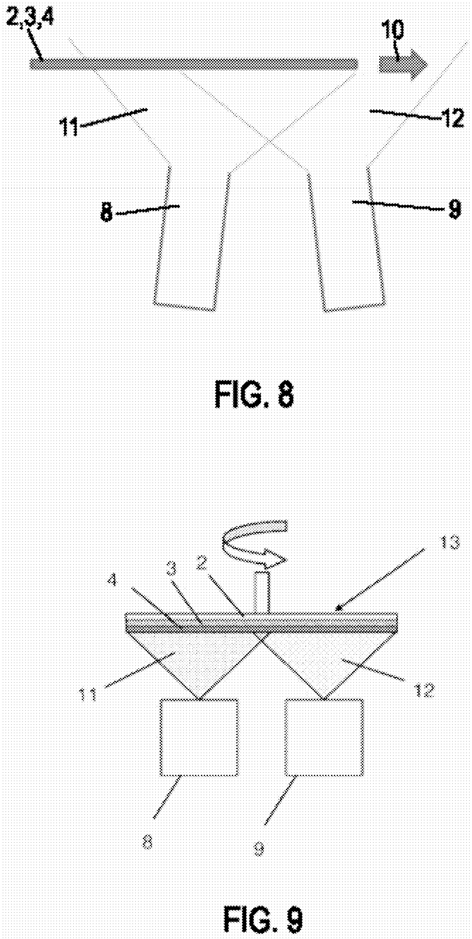

Fig. 8 is a schematic representation of an in-line method for producing a buffer layer 5 made of $A_xIn_yS_z$ with A = potassium or cesium. The substrate 2 with rear electrode 3 and absorber layer 4 is conveyed past the first steam beam 11 of a first source 8 and past a second steam beam 12 of a second source 9. The transport direction is indicated by an arrow with the reference character 10. As illustrated schematically, the steam beams 11, 12 of the two sources 8, 9 overlap partially.

Potassium compounds or cesium compounds and indium sulfide can be used as starting materials for producing a semiconductor material of the formula $K_x In_y S_z$ or $Cs_x In_y S_z$. Accordingly, the first source 8 is a potassium and/or cesium source 8; and the second source 9, an indium sulfide source. For example, compounds of potassium or cesium with the chalcogen sulfur, in particular $K_2 S$ or $Cs_2 S$, can be used. Alternatively, halogen salts of potassium or cesium can be used, for example, potassium fluoride (KF) or cesium fluoride (CsF), potassium chlorid (KC1) or cesium chloride (CsCl), or corresponding bromides or iodides. This offers advantages, particularly through easier handling of these relatively harmless materials in a production environment. In this manner, the absorber layer 4 is coated with thin layers of a halogen or sulfide of potassium or cesium and indium sulfide, which blend. The two sources 8, 9 are, for example, effusion cells, from which the respective substance is thermally evaporated. Alternatively, any other form of generating steam beams 11, 12 is suitable for depositing the buffer layer 5, so long as it enables establishing the required ratio of the mole fractions of potassium or cesium as well as indium and sulfur. Alternative sources are, for example, boats of linear evaporators or crucibles of electron-beam evaporators. Since the potassium or cesium compound is deposited before the indium sulfide on the absorber layer 4, electrical passivation of the interface can be obtained, by means of which the efficiency of the solar cell is improved.

Alternatively, for performance of the method according to the invention, one or a plurality of sources of potassium or cesium 8 and one or plurality of sources of indium sulfide 9 can be alternatingly arranged one- or two-dimensionally such that

- two or more potassium or cesium layers are deposited alternatingly with one or plurality of indium sulfide layers, or
- two or more indium sulfide layers are deposited alternatingly with one or plurality of potassium or cesium layers,

on the absorber layer 4. Thus, a very homogeneous buffer layer 5 can be produced, by which means the efficiency of the solar cell is increased. It is particularly advantageous for a potassium or cesium layer to be applied as the first layer on the absorber layer 4, in order to obtain electrical passivation of the interface for further improvement of efficiency.

Alternatively, it is possible to use only at least one ternary potassium indium sulfur compound, for example, $KInS_2$, $KIn_3S_5$, $KIn_5S_6$, $KIn_5S_7$, and/or $KIn_5S_8$, as starting materials for producing a semiconductor material of the formula $K_x In_y S_z$, and to use only at least one ternary cesium indium sulfur compound, for example, $CsInS_2$, $CsIn_3S_5$, $CsIn_5S_6$, $CsIn_5S_7$, and/or $CsIn_5S_8$, as starting materials for producing a semiconductor material of the formula $Cs_x In_y S_z$. The use of indium sulfide is dispensed with here. Accordingly, the first source 8 is a source for a ternary potassium indium sulfur compound and the second source 9 is a source for a ternary cesium indium sulfur compound. It is also possible for the first source 8 to be a source for a first ternary potassium indium sulfur compound and the second source 9 to be a source for a second ternary potassium indium sulfur compound different therefrom. Similarly, it is also possible for the first source 8 to be a source for first ternary cesium indium sulfur compound and the second source 9 to be a source for a second ternary cesium indium sulfur compound different therefrom. It is also conceivable, in each case, to use more than two sources 8, 9. As already stated, the use of the ternary potassium indium sulfur compound as well as the ternary cesium indium sulfur compound bring with them significant process technology advantages. It is conceivable for the two sources to contain the same ternary potassium indium sulfur compound or the same ternary cesium indium sulfur compound. It is also conceivable for only one source 8 with only one ternary potassium indium sulfur compound or only one ternary cesium indium sulfur compound to be present.

Fig. 9 depicts an alternative embodiment of the method according to the invention using the example of a rotation method. The substrate 2 with rear electrode 3 and absorber layer 4 is arranged on a rotatable sample carrier 13, for example, on a sample carousel. Alternatingly arranged sources of potassium or cesium 8 and indium sulfide 9 are situated below the sample carrier 13. During the deposition of the buffer layer 5, the sample carrier 13 is rotated. Thus, the substrate 2 is moved into the steam beams 11, 12 and coated.

Both in the lab process with a rotating substrate 2 on a rotatable sample carrier 13 and also in the industrial in-line method with linear feed of the substrate 2, the evaporation rates of sources 8,9 can be selected such that the fraction of potassium and/or cesium varies such that a potassium and/or cesium gradient can be generated in the buffer layer 5.

Alternatively, with regard to the sources 8, 9 of Fig. 9, the first source 8 can be a source for a ternary potassium indium sulfur compound or a ternary cesium indium sulfur compound, and the second source 9 can be a source for a ternary potassium indium sulfur compound or a ternary cesium indium sulfur compound.

From the above assertions, it has become clear that by means of the present invention, the disadvantages of previously used CdS buffer layers could be overcome in thin-film solar cells, with the efficiency and the stability of the solar cells produced therewith also very good or better. This is been achieved by means of an indium sulfide buffer layer provided with potassium or cesium. Through the introduction of potassium or cesium, different crystal structures are formed, which results in a fine crystalline layer during layer growth. In addition, the relatively large atomic radius disrupts the formation of the indium sulfide crystal structure and, thus, also reduces the crystallinity. Compared to sodium, potassium and cesium have a larger ionic radius and thus have a reduced diffusion tendency. By means of potassium and cesium, the optical bandgap of the indium sulfide buffer layer can be widened. Compared to the sodium-containing indium sulfide buffer layers, better band adaptation, reduced light absorption, as well as a significant increase in the short-circuit current and improved transmittance, as well as, overall, higher efficiency can be obtained. At the same time, the production method is economical, effective, and environmentally safe.

It has been demonstrated that with the layer system according to the invention, comparably good solar cell characteristics can be obtained as are present with conventional CdS buffer layers. With the structure according to the invention, it was possible to obtain very high efficiencies up to 16%. This was unexpected and surprising for the person skilled in the art.

List of Reference Characters

1       layer system
2       substrate
3       rear electrode
4       absorber layer
5       first buffer layer
6       second buffer layer
7       front electrode
8       first source
9       second source
10      transport direction
11      first steam beam
12      second steam beam
13      sample carrier
100     thin-film solar cell

**Claims**

1. Layer system (1) for thin-film solar cells (100), comprising:

   - an absorber layer (4), which contains a chalcogenide compound semiconductor,
   - a buffer layer (5), which is arranged on the absorber layer (4), wherein the buffer layer (5) has a semiconductor material of the formula $A_xIn_yS_z$, where A is potassium (K) and/or cesium (Cs), with

   $$0.015 \leq x/(x+y+z) \leq 0.25,$$

   and

   $$0.30 \leq y/(y+z) \leq 0.45.$$

2. Layer system (1) according to claim 1, wherein in the buffer layer (5)

   $$0.05 \leq x/(x+y+z) \leq 0.20$$

   and

   $$0.35 \leq y/(y+z) \leq 0.45.$$

3. Layer system (1) according to claim 1, wherein in the buffer layer (5) with A = K

   $$0.05 \leq x/(x+y+z) \leq 0.15$$

   and

   $$0.35 \leq y/(y+z) \leq 0.45.$$

4. Layer system (1) according to claim 1, wherein in the buffer layer (5) with A = Cs

   $$0.05 \leq x/(x+y+z) \leq 0.12$$

   and

   $$0.35 \leq y/(y+z) \leq 0.45.$$

5. Layer system (1) according to one of the preceding claims 1 through 4, wherein the buffer layer (5) has at least one halogen, selected in particular from the group consisting of fluorine (F), chlorine (Cl), bromine (Br), and iodine (I).

6. Layer system (1) according to claim 5, wherein a halogen content of the buffer layer (5) corresponds to an alkali content of the buffer layer (5).

7. Layer system (1) according to one of the preceding claims 1 through 6, wherein a second buffer layer (6) is arranged on an $A_xIn_yS_z$-containing first buffer layer (5), wherein the second buffer layer (6) contains, in particular, non-doped zinc oxide (ZnO) and/or non-doped zinc magnesium oxide (ZnMgO).

8. Layer system (1) according to one of the preceding claims 1 through 7, wherein the buffer layer (5) contains zinc (Zn), wherein the zinc content is a maximum of 15 atom-%.

9. Layer system (1) according to one of the preceding claims 7 and 8, wherein the zinc content of the first buffer layer (5) increases to the second buffer layer (6) .

**10.** Thin-film solar cell (100), comprising:

- a substrate (2),
- a rear electrode (3), which is arranged on the substrate (2),
- a layer system (1) according to one of claims 1 through 9, which is arranged on the rear electrode (3), and
- a front electrode (7), which is arranged on the layer system (1).

**11.** Method for producing a layer system (1) according to one of the preceding claims 1 through 9, wherein

a) an absorber layer (4), which contains a chalcogenide compound semiconductor, is prepared, and
b) a buffer layer (5) is arranged on the absorber layer (4), wherein the buffer layer has a semiconductor material of the formula $A_xIn_yS_z$ with $0.015 \leq x/(x+y+z) \leq 0.25$ and $0.30 \leq y/(y+z) \leq 0.45$, where A is potassium and/or cesium, wherein the buffer layer (5) is produced on the basis of at least one potassium compound and indium sulfide and/or on the basis of at least one cesium compound and indium sulfide, in particular by atomic layer deposition (ALD), ion layer gas deposition (ILGAR), spray pyrolysis, chemical vapor deposition (CVD), or physical vapor deposition (PVD), sputtering, thermal evaporation, or electron beam evaporation, in particular from separate sources for the potassium compound and/or cesium compound and indium sulfide.

**12.** Method according to claim 11, wherein the absorber layer (4) is conveyed, in an in-line method or a rotation method, past at least one steam beam (11) of a potassium compound and/or a cesium compound and at least one steam beam (12) of indium sulfide, in particular with at least partially overlapping steam beams (11, 12).

**13.** Method according to claim 11 or 12, wherein the buffer layer (5) is produced on the basis of at least one potassium halide and/or at least one binary potassium compound, in particular potassium sulfide, and/or at least one ternary potassium compound, in particular at least one ternary potassium indium sulfur compound, for example, $KInS_2$, $KIn_3S_5$, $KIn_5S_6$, $KIn_5S_7$, and/or $KIn_5S_8$, and/or at least one cesium halide and/or at least one binary cesium compound, in particular cesium sulfide, and/or at least one ternary cesium compound, in particular at least one ternary cesium indium sulfur compound, for example,

$CsInS_2$, $CsIn_3S_5$, $CsIn_5S_6$, $CsIn_5S_7$, and/or $CsIn_5S_8$.

**14.** Method for producing a layer system (1) according to one of the preceding claims 1 through 9, wherein

a) an absorber layer (4), which contains a chalcogenide compound semiconductor, is prepared, and
b) a buffer layer (5) is arranged on the absorber layer (4), wherein the buffer layer has a semiconductor material of the formula $A_xIn_yS_z$ with $0.015 \leq x/(x+y+z) \leq 0.25$ and $0.30 \leq y/(y+z) \leq 0.45$, where A is potassium and/or cesium, wherein the buffer layer (5) is produced on the basis of at least one ternary potassium indium sulfur compound, for example, $KInS_2$, $KIn_3S_5$, $KIn_5S_6$, $KIn_5S_7$, and/or $KIn_5S_8$, and/or on the basis of at least one ternary cesium indium sulfur compound, for example, $CsInS_2$, $CsIn_3S_5$, $CsIn_5S_6$, $CsIn_5S_7$, and/or $CsIn_5S_8$, in particular by atomic layer deposition (ALD), ion layer gas deposition (ILGAR), spray pyrolysis, chemical vapor deposition (CVD), or physical vapor deposition (PVD), sputtering, thermal evaporation, or electron beam evaporation.

**15.** Method according to claim 14, wherein, in step b), the buffer layer (5) is deposited out of the gas phase, wherein the concentration of at least one component of the material to be deposited is reduced by selective bonding in its gas phase and thus, before its deposition on the absorber layer (4).

**16.** Method according to claim 14 or 15, wherein the absorber layer (4) is conveyed, in an in-line method or a rotation method, past a steam beam (11) of a ternary potassium indium sulfur compound and/or past a steam beam (11) of a ternary cesium indium-sulfur compound, in particular with at least partially overlapping steam beams (11, 12).

**Patentansprüche**

**1.** Schichtsystem (1) für Dünnschichtsolarzellen (100), umfassend:

- eine Absorberschicht (4), die einen Chalkogenid-Verbindungshalbleiter enthält,
- eine Pufferschicht (5), die auf der Absorberschicht (4) angeordnet ist, wobei die Pufferschicht (5) ein Halbleitermaterial der Formel $A_xIn_yS_z$ aufweist, wobei A Kalium (K) und/oder Cäsium (Cs) ist, mit

$$0{,}015 \leq x/(x+y+z) \leq 0{,}25$$

und

$$0,30 \leq y/(y+z) \leq 0,45.$$

2. Schichtsystem (1) nach Anspruch 1, wobei in der Pufferschicht (5)

$$0,05 \leq x/(x+y+z) \leq 0,20$$

und

$$0,35 \leq y/(y+z) \leq 0,45$$

beträgt.

3. Schichtsystem (1) nach Anspruch 1, wobei in der Pufferschicht (5) mit A = K

$$0,05 \leq x/(x+y+z) \leq 0,15$$

und

$$0,35 \leq y/(y+z) \leq 0,45$$

beträgt.

4. Schichtsystem (1) nach Anspruch 1, wobei in der Pufferschicht (5) mit A = Cs

$$0,05 \leq x/(x+y+z) \leq 0,12$$

und

$$0,35 \leq y/(y+z) \leq 0,45$$

beträgt.

5. Schichtsystem (1) nach einem de vorhergehenden Ansprüche 1 bis 4, wobei die Pufferschicht (5) wenigstens ein Halogen, insbesondere gewählt aus der Gruppe, bestehend aus Fluor (F), Chlor (Cl), Brom (Br) und Iod (I), aufweist.

6. Schichtsystem (1) nach Anspruch 5, wobei ein Halogengehalt der Pufferschicht (5) einem Alkaligehalt der Pufferschicht (5) entspricht.

7. Schichtsystem (1) nach einem der vorhergehenden Ansprüche 1 bis 6, wobei auf einer $A_xIn_yS_z$ enthaltenden ersten Pufferschicht (5) eine zweite Pufferschicht (6) angeordnet ist, wobei die zweite Pufferschicht (6) insbesondere undotiertes Zinkoxid (ZnO) und/oder undotiertes Zink-Magnesiumoxid (ZnMgO) enthält.

8. Schichtsystem (1) nach einem der vorhergehenden Ansprüche 1 bis 7, wobei die Pufferschicht (5) Zink (Zn) enthält, wobei der Zinkgehalt maximal 15 Atom-% beträgt.

9. Schichtsystem (1) nach einem der vorhergehenden Ansprüche 7 und 8, wobei der Zinkgehalt der ersten Pufferschicht (5) zur zweiten Pufferschicht (6) hin ansteigt.

10. Dünnschichtsolarzelle (100), umfassend:

   - ein Substrat (2),
   - eine Rückelektrode (3), die auf dem Substrat (2) angeordnet ist,
   - ein Schichtsystem (1) nach einem der Ansprüche 1 bis 9, das auf der Rückelektrode (3) angeordnet ist, und
   - eine Frontelektrode (7), die auf dem Schichtsystem (1) angeordnet ist.

11. Verfahren zur Herstellung eines Schichtsystems (1) nach einem der vorhergehenden Ansprüche 1 bis 9, bei welchem

   a) eine Absorberschicht (4), die einen Chalkogenid-Verbindungshalbleiter enthält, bereitgestellt wird und
   b) eine Pufferschicht (5) auf der Absorberschicht (4) angeordnet wird, wobei die Pufferschicht ein Halbleitermaterial der Formel $A_xIn_yS_z$ aufweist, mit $0,015 \leq x/(x+y+z) \leq 0,25$ und $0,30 \leq y/(y+z) \leq 0,45$, wobei A Kalium (K) und/oder Cäsium (Cs) ist, wobei die Pufferschicht (5) hergestellt wird auf der Basis wenigstens einer Kalium-Verbindung und Indiumsulfid und/oder auf der Basis wenigstens einer Cäsium-Verbindung und Indiumsulfid, insbesondere durch Atomic Layer Deposition (ALD), Ion Layer Gas Deposition (ILGAR), Sprühpyrolyse, Chemical Vapour Deposition (CVD) oder Physical Vapor Deposition (PVD), Sputtern, thermisches Verdampfen oder Elektronenstrahlverdampfen, insbesondere aus separaten Quellen für die Kalium- und/oder Cäsium-Verbindung und Indiumsulfid.

12. Verfahren nach Anspruch 11, wobei die Absorberschicht (4) in einem In-Line-Verfahren oder Rotations-Verfahren an mindestens einer Dampfkeule (11) einer Kalium- und/oder Cäsium-Verbindung und mindestens einer Dampfkeule (12) von Indiumsulfid vorbeigeführt wird, insbesondere mit wenigstens teilweise überlappenden Dampfkeulen (11, 12).

**13.** Verfahren nach Anspruch 11 oder 12, bei welchem die Pufferschicht (5) hergestellt wird auf der Basis wenigstens eines Kaliumhalids und/oder wenigstens einer binären Kaliumverbindung, insbesondere Kaliumsulfid, und/oder wenigstens einer ternären Kaliumverbindung, insbesondere wenigstens eine ternäre Kalium-Indium-Schwefel-Verbindung, zum Beispiel $KInS_2$, $KIn_3S_5$, $KIn_5S_6$, $KIn_5S_7$ und/oder $KIn_5S_8$, und/oder wenigstens ein Cäsiumhalid und/oder wenigstens eine binäre Cäsiumverbindung, insbesondere Cäsiumsulfid und/oder wenigstens eine ternäre Cäsiumverbindung, insbesondere wenigstens eine ternäre Cäsium-Indium-Schwefel-Verbindung, zum Beispiel $CsInS_2$, $CsIn_3S_5$, $CsIn_5S_6$, $CsIn_5S_7$ und/oder $CsIn_5S_8$.

**14.** Verfahren zur Herstellung eines Schichtsystems (1) nach einem der vorhergehenden Ansprüche 1 bis 9, bei welchem

a) eine Absorberschicht (4), die einen Chalkogenid-Verbindungshalbleiter enthält, bereitgestellt wird und
b) eine Pufferschicht (5) auf der Absorberschicht (4) angeordnet wird, wobei die Pufferschicht ein Halbleitermaterial der Formel $A_xIn_yS_z$ aufweist, mit $0,015 \le x/(x+y+z) \le 0,25$ und $0,30 \le y/(y+z) \le 0,45$, wobei A Kalium (K) und/oder Cäsium (Cs) ist, wobei die Pufferschicht (5) hergestellt wird auf der Basis wenigstens einer ternären Kalium-Indium-Schwefel-Verbindung, zum Beispiel $KInS_2$, $KIn_3S_5$, $KIn_5S_6$, $KIn_5S_7$ und/oder $KIn_5S_8$, und/oder auf der Basis wenigstens einer ternären Cäsium-Indium-Schwefel-Verbindung, zum Beispiel $CsInS_2$, $CsIn_3S_5$, $CsIn_5S_6$, $CsIn_5S_7$ und/oder $CsIn_5S_8$, insbesondere durch Atomic Layer Deposition (ALD), Ion Layer Gas Deposition (ILGAR), Sprühpyrolyse, Chemical Vapour Deposition (CVD) oder Physical Vapor Deposition (PVD), Sputtern, thermisches Verdampfen oder Elektronenstrahlverdampfen.

**15.** Verfahren nach Anspruch 14, bei welchem, in Schritt b), die Pufferschicht (5) aus der Gasphase abgeschieden wird, wobei die Konzentration wenigstens einer Komponente des abzuscheidenden Materials durch selektive Bindung in ihrer Gasphase vermindert wird, und somit vor ihrer Abscheidung auf der Absorberschicht (4).

**16.** Verfahren nach Anspruch 14 oder 15, wobei die Absorberschicht (4) in einem In-Line-Verfahren oder Rotations-Verfahren an einer Dampfkeule (11) einer ternären Kalium-Indium-Schwefel-Verbindung und/oder einer ternären Cäsium-Indium-Schwefel-Verbindung vorbeigeführt wird, insbesondere mit wenigstens teilweise überlappenden Dampfkeulen (11, 12).

**Revendications**

**1.** Système de couches (1) pour cellules solaires à film mince (100), comprenant :

- une couche absorbante (4), qui contient un semi-conducteur composé de chalcogénure,
- une couche tampon (5), qui est disposée sur la couche absorbante (4), où la couche tampon (5) contient un matériau semi-conducteur de la formule $A_xIn_yS_z$ où A représente le potassium (K) et/ou le césium (CS), et

$$0,015 \le x/(x+y+z) \le 0,25$$

et

$$0,30 \le y/(y+z) \le 0,45.$$

**2.** Système de couches (1) selon la revendication 1, où dans la couche tampon (5),

$$0,05 \le x/(x+y+z) \le 0,20$$

et

$$0,35 \le y/(y+z) \le 0,45.$$

**3.** Système de couches (1) selon la revendication 1, où dans la couche tampon (5), où A = K

$$0,05 \le x/(x+y+z) \le 0,15$$

et

$$0,35 \le y/(y+z) \le 0,45.$$

**4.** Système de couches (1) selon la revendication 1, où dans la couche tampon (5), où A = CS

$$0,05 \le x/(x+y+z) \le 0,12$$

et

$$0,35 \le y/(y+z) \le 0,45.$$

**5.** Système de couches (1) selon l'une des revendications précédentes 1 à 4, où la couche tampon (5) contient au moins un halogène, sélectionné en particulier parmi le groupe composé de fluor (F), chlore (CL), brome (BR) et iode (I).

**6.** Système de couches (1) selon la revendication 1, où une teneur de halogène et conformément à une teneur de l'alcali de la couche tampon (5).

**7.** Système de couches (1) selon l'une des revendications précédentes 1 à 6, où une deuxième couche tampon (6) est disposée sur une première couche tampon (5) contenant du $A_xIn_yS_z$, où la deuxième couche tampon (6) contient, en particulier, de l'oxyde de zinc (ZnO) non dopé et/ou de l'oxyde de zinc magnésium (ZnMgO) non dopé.

**8.** Système de couches (1) selon l'une des revendications précédentes 1 à 7, où la couche tampon (6) contient du zinc, où une teneur du zinc est 15 at.-% au maximum.

**9.** Système de couches (1) selon l'une des revendications précédentes 7 et 8, où la teneur du zinc grandit en direction de la deuxième couche tampon (6).

**10.** Cellule solaire à film mince (100), comprenant :

- un substrat (2),
- une électrode arrière (3), qui est disposée sur le substrat (2),
- un système de couches (1) selon l'une des revendications 1 à 9, disposé sur l'électrode arrière (3) et
- une électrode avant (7), qui est disposée sur le système de couches (1).

**11.** Méthode de fabrication d'un système de couches (1) selon l'une des revendications précédentes 1 à 9, où

a) une couche absorbante (4), qui contient un semi-conducteur composé de chalcogénure, est préparé, et
b) une couche tampon (5) est disposée sur la couche absorbante (4), où la couche tampon présente un matériau semi-conducteur avec la formule $A_xIn_yS_z$ où $0,015 \leq x/(x+y+z) \leq 0,25$ et $0,30 \leq y/(y+z) \leq 0,45$, où A représente le potassium et/ou le césium, où la couche tampon (5) est produite sur la base d'au moins un composé de potassium et de sulfure d'indium et/ou sur le base d'au moins un composé de césium et de sulfure d'indium, en particulier par dépôt de couches atomiques (ALD), dépôt de couches d'ions en phase gazeuse (ILGAR), pyrolyse à pulvérisation, dépôt chimique en phase vapeur (CVD), ou dépôt physique en phase vapeur (PVD), pulvérisation cathodique (sputtering), évaporation thermique ou évaporation par faisceau d'électrons, en particulier en provenance de sources distinctes pour le composé de potassium et/ou le composé de césium et le sulfure d'indium.

**12.** Méthode selon la revendication 11, où la couche absorbante (4) est transmise, dans une méthode en ligne ou une méthode de rotation, devant au moins un faisceau de vapeur (11) d'un composé de potassium et/ou d'un composé de césium et devant au moins un faisceau de vapeur (12) de sulfure d'indium, en particulier avec un chevauchement au moins partiel des faisceaux de vapeur (11, 12).

**13.** Méthode selon l'une des revendications 11 ou 12, où la couche tampon (5) est produite sur la base d'au moins un halogénure de potassium et/ou au moins un composé binaire de potassium, en particulier le sulfure de potassium, et/ou au moins un composé ternaire de potassium, en particulier au moins un composé ternaire de potassium-indium-soufre, par exemple $KInS_2$, $KIn_3S_5$, $KIn_5S_6$, $KIn_5S_7$, et/ou $KIn_5S_8$, et/ou au moins un halogénure de césium et/ou au moins un composé binaire de césium, en particulier le sulfure de césium, et/ou au moins un composé ternaire de césium, en particulier au moins un composé ternaire de césium-indium- soufre, par exemple, $CsInS_2$, $CsIn_3S_5$, $CsIn_5S_6$, $CsIn_5S_7$, et/ou $CsIn_5S_8$.

**14.** Méthode de fabrication d'un système de couches (1) selon l'une des revendications précédentes 1 à 9, où

a) une couche absorbante (4), qui contient un semi-conducteur composé de chalcogénure, est préparé, et
b) une couche tampon (5) est disposée sur la couche absorbante (4), où la couche tampon présente un matériau semi-conducteur avec la formule $A_xIn_yS_z$ où $0,015 \leq x/(x+y+z) \leq 0,25$ et $0,30 \leq y/(y+z) \leq 0,45$, où A représente le potassium et/ou le césium, où la couche tampon (5) est produite sur la base d'au moins un composé ternaire de potassium-soufre-indium, par exemple, $KInS_2$, $KIn_3S_5$, $KIn_5S_6$, $KIn_5S_7$, et/ou $KIn_5S_8$, et/ou sur la base d'au moins un composé ternaire de césium-indium-soufre, par exemple $CsInS_2$, $CsIn_3S_5$, $CsIn_5S_6$, $CsIn_5S_7$, et/ou $CsIn_5S_8$, en particulier par dépôt de couches atomiques (ALD), dépôt de couches d'ions en phase gazeuse (ILGAR), pyrolyse à pulvérisation, dépôt chimique en phase vapeur (CVD), ou dépôt physique en phase vapeur (PVD), pulvérisation cathodique (sputtering), évaporation thermique ou évaporation par faisceau d'électrons.

**15.** Méthode selon la revendication 14, où, lors de l'étape b), la couche tampon (5) est déposée hors de la phase gazeuse, où la concentration d'au moins un composant de la matière à déposer est réduite par une liaison sélective dans sa phase gazeuse et donc, avant sa déposition sur la couche absorbante (4).

16. Méthode selon la revendication 14 ou 15, où la couche absorbante (4) est transmise, dans une méthode en ligne ou une méthode de rotation, devant un faisceau de vapeur (11) d'un composé ternaire de potassium-soufre-indium et/ou devant un faisceau de vapeur (11) d'un composé ternaire de césium-soufre-indium, en particulier avec un chevauchement au moins partiel des faisceaux de vapeur (11,12).

100

7

6

5

4

3

1

2

FIG. 1

FIG. 2

FIG. 3

FIG. 4

FIG. 5

FIG. 6

FIG. 7

FIG. 8

FIG. 9

**EP 3 087 615 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009141132 A2
- EP 1356528 A1
- WO 2011104235 A
- DE 19956735 B4